# EUROPEAN PATENT SPECIFICATION

(11) **EP 1 114 575 B1**
(45) Date of publication and mention of the grant of the patent: **08.05.2002**
(21) Application number: 99943328.7
(22) Date of filing: 14.09.1999
(51) Int. Cl.: H05K 13/04, H05K 13/08

(54) **METHOD AND APPARATUS FOR FEEDING COMPONENT, AND METHOD AND APPARATUS FOR MOUNTING COMPONENT**
VERFAHREN UND VORRICHTUNG ZUM ZUFÜHREN VON BAUTEILEN, UND VERFAHREN UND EINRICHTUNG ZUR MONTAGE VON BAUTEILEN
PROCEDE ET APPAREIL D'APPROVISIONNEMENT EN PIECES, ET PROCEDE ET APPAREIL DE MONTAGE DE PIECES

(30) Priority: 17.09.1998 JP 26294798
(43) Date of publication of application: 11.07.2001
(73) Proprietor: MATSUSHITA ELECTRIC INDUSTRIAL CO., LTD., Kadoma-shi, Osaka 571-8501 (JP)
(72) Inventor: KURIBAYASHI, Takeshi, Yamanashi 409-3822 (JP); UCHIYAMA, Hiroshi, Kofu-shi Yamanashi 400-0056 (JP); WACHI, Akihiko Mezon-itoue 210, Yamanashi 409-3861 (JP)
(74) Representative: Eisenführ, Speiser & Partner
(86) International application number: PCT/JP99/05005
(87) International publication number: WO 00/18208

(56) References cited:
- WO-A-98/32318
- PATENT ABSTRACTS OF JAPAN vol. 016, no. 465 (E-1270), 28 September 1992 (1992-09-28) & JP 04 164398 A (MATSUSHITA ELECTRIC IND CO LTD), 10 June 1992 (1992-06-10) cited in the application

## Description

### Technical Field

The present invention relates to a method and an apparatus for feeding components which are supplied to a component holding member such as a mounting head or the like which takes the components out of a component feed part in turn mounts the taken-out components to a mounting position on a printed board, a method for mounting the components supplied by the component feed method to the board, and an apparatus for mounting the components supplied by the component feeding apparatus to the board.

### Background Art

Productivity improvement has been required in component mounting apparatuses these days. Particularly production interruption subsequent to switching of product types (kinds) and lack of components adversely influences productivity, and therefore improvement in the field is strongly demanded.

One prior art known for enhancing operation of a component feed part of the component mounting apparatus is disclosed, e.g., in Japanese Unexamined Patent Publication No. 60-206098.

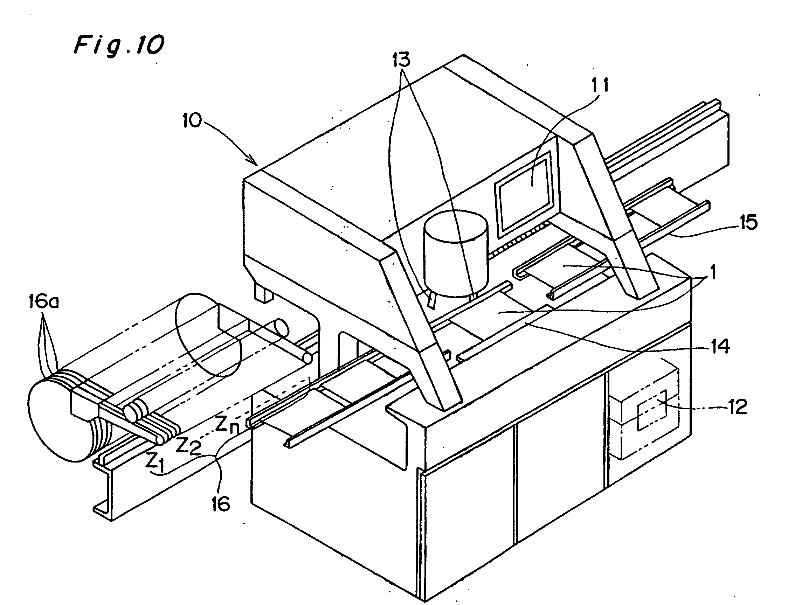

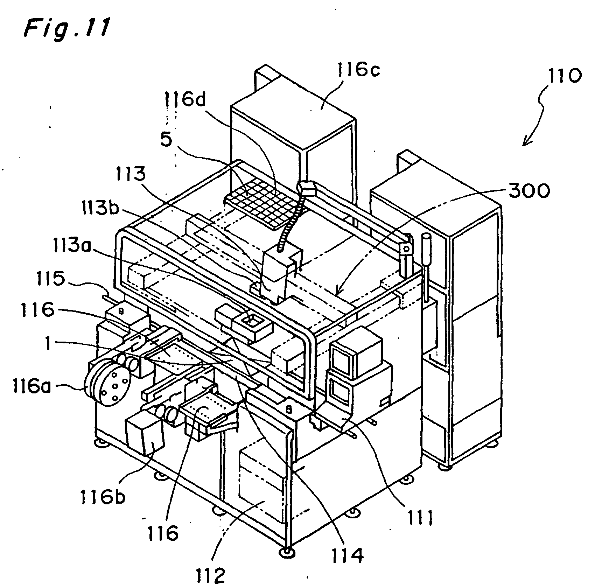

The prior art apparatus will be described below with reference to Figs. 10 and 11.

The constitution of the entire component mounting apparatus will be schematically depicted first. Fig. 10 shows the component mounting apparatus of a high-speed type, and Fig. 11 is the component mounting apparatus of a multi-functional middle-speed type.

In Fig. 10, a component mounting apparatus 10 of a high-speed type comprises an operation part 11, a control part 12, mounting heads 13, a mounting table 14, a transfer rail 15, and a component feed part 16. The component feed part 16 loads a plurality of parts cassettes 16a which slide to feed predetermined components to the mounting heads 13. The mounting table 14 holds printed boards 1 and positions the boards sequentially to mount the predetermined components.

In Fig. 11, a component mounting apparatus 110 of a multi-functional middle-speed type comprises an operation part 111, a control part 112, a mounting head 113, a board recognition device 113a, a component inspection part 113b, a mounting table 114, a transfer rail 115, and a component feed part 116. The component feed part 116 is equipped with a parts cassette 116a, a bulk cassette 116b, a parts tray container part 116c, and parts trays 116d, so that many kinds of components 5 can be supplied from the component feed part 116. The mounting head 113 takes out electronic component 5 from the component feed part 116, moves the component to a predetermined component mounting position of the mounting table 114, then mounts the component onto printed boards 101.

The following description will be directed to how the component feed part is switched to cope with a lack of components in the component mounting apparatus conventionally.

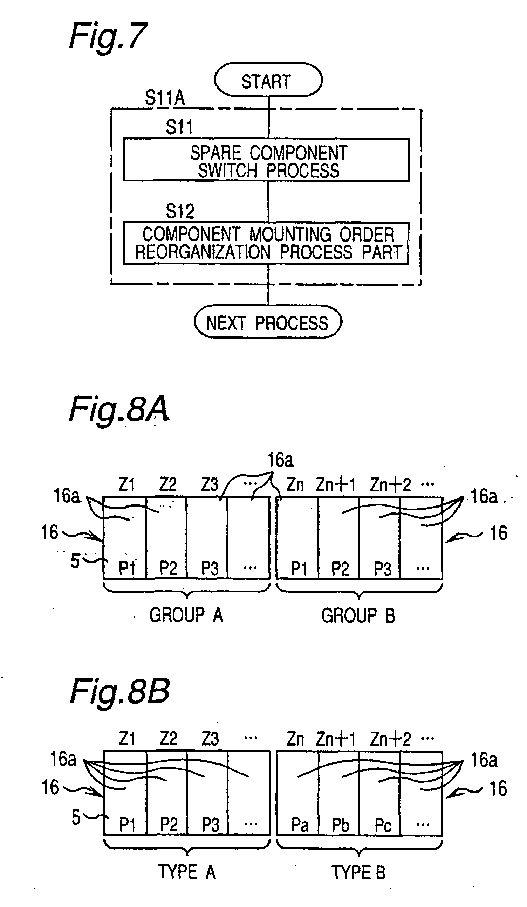

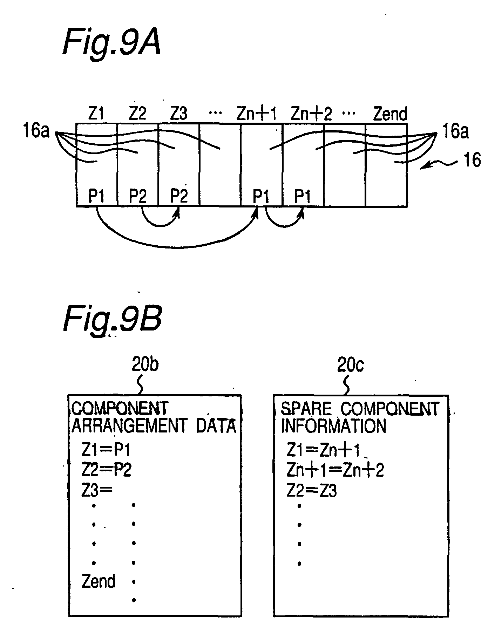

Fig. 8A is a diagram explanatory of an example of a conventional exchange mode, Fig. 8B is a diagram explanatory of an example of a conventional preparation mode, Figs. 9A and 9B are schematic diagrams of examples of a conventional switch mode in an alternate operation and a mounting program, respectively.

According to the conventional exchange mode shown in Fig. 8A, the component feed part 16, 116 is divided to two groups A and B, and the same parts are arranged at the same positions in the groups A and B respectively, so that, for instance, the group A if lacking in components is switched to the group B.

In the conventional preparation mode shown in Fig. 8B, the component feed part 16, 116 is divided to two groups A and B and, components to be mounted to A-type boards and B-type boards are arranged in the groups A and B respectively, thereby coping with switching of types of boards to be produced.

As is disclosed in the publication No. 60-206098 referred to earlier, according to the conventional alternate operation shown in Figs. 9A and 9B, spare components are taken out and used from cassettes of a preliminarily designated spare component feed part when the component feed part lacks in the components (in other words, the component feed part is switched to the spare component feed part), so that the production is continued. More specifically, when a parts cassette P1 by way of. example runs out of stock of components in the component feed part 16, 116, the component feed part is switched at a feed position Zl=Zn, Zn=Zn+l designated by a spare component information 20c, thereby automatically switching to spare components to continue the production.

In the above-described prior art constitution, it is necessary to construct the component feed part for spare components into units for each kind of boards to be produced, or set spare components at the component feed part in the same arrangement for each kind of boards to be produced, that is, it is necessary to assign component information (referred to as the spare component information hereinafter) indicating respective set positions of spare components at the component feed part, etc. within a mounting program (relating to NC program or component arrangement or the like) designed for mounting components to printed boards of optional kinds.

Components should be set at a designated component feed position at the component feed part. The mounting program indicating the spare component information should be formed for each kind of boards in the case of production of a wide variety with a relatively low volume.

Moreover, the-mounting program should be replaced or the like preparation process is needed in switching kinds of boards to be produced. In other words, the switching is complicate and takes time, thereby increasing an operator's burden for preparation, management, etc. of the switching.

If spare components are set at a wrong position at the time of switching the production and when the component feed part runs out of stock of components, components designated as the spare components at the component feed position although the position is wrong are automatically continuously mounted in the exchange mode or alternate operation, resulting in a quality issue.

At the execution of the exchange mode or alternate operation, the operation is wasted if the components are mounted in a mounting order before changed, with greatly worsening a production time per one board, i.e., mounting cycle time and deteriorating productivity.

### Disclosure Of Invention

The present invention is devised to solve the above-described issues and has for its object to provide a method and an apparatus for feeding components, and a method and an apparatus for mounting components which realize production of higher flexibility, high productivity, and high quality in an exchange mode or alternate operation of automatically switching component with spare components even though component lack is occurred and enabling continuous mounting to boards.

In accomplishing these and other aspects, according to the present invention; there is provided a component feed method as defined in appended claim 1 and a component mounting method as defined in appended claim 6.

According to the present invention, there is provided a component mounting apparatus as defined in appended claim 7.

### Brief Description Of Drawings

These and other aspects and features of the present invention will become clear from the following description taken in conjunction with the preferred embodiments thereof with reference to the accompanying drawings, in which:
Fig. 1 is a flow chart of a component mounting method including a component feed method (free alternate operation) according to a first embodiment of the present invention;
Fig. 2 is a block diagram schematically showing a mounting control part of a component mounting apparatus according to the first embodiment of the present invention;
Fig. 3 is a partial perspective view schematically showing the component mounting apparatus equipped with the component feed method and component mounting method according to the first embodiment of the present invention;
Fig. 4 is a partial perspective view schematically showing a component mounting apparatus equipped with a component feed method and a component mounting method according to a second embodiment of the present invention;
Fig. 5A is a schematic explanatory diagram of how spare components are switched at a component feed part in the component mounting apparatus according to the first embodiment of the present invention, that is, in detail, a schematic diagram of an arrangement example at the component feed part with a component feed area and a spare component feed area;
Fig. 5B is a schematic diagram of a mounting program for two types, i.e., A and B types of boards in the apparatus;
Fig. 5C is a schematic diagram of an arrangement example of the spare component feed area at the component feed part in the apparatus;
Fig. 6 is a schematic explanatory diagram indicating a part of a mounting control part for carrying out a spare component designation process in a component mounting feed method according to a third embodiment of the present invention;
Fig. 7 is a schematic flow of processes in the fourth embodiment of the present invention;
Fig. 8A is a diagram showing an example of a conventional exchange mode;
Fig. 8B is a diagram showing an example of a conventional preparation mode;
Figs. 9A and 9B are schematic diagrams of examples of the conventional exchange mode in an alternate operation and a mounting program;
Fig. 10 is a partial perspective view of a conventional example of a high-speed type component mounting apparatus;
Fig. 11 is a partial perspective view of a conventional different example of a multi-functional middle-speed type component mounting apparatus; and
Fig. 12 is a partial perspective view schematically showing the component mounting apparatus equipped with the component feed method and component mounting method according to the second embodiment which has a multi-nozzle type mounting head for holding a plurality of, four in the figure, components.

### Best Mode for Carrying Out the Invention

Before the description of the present invention proceeds, it is to be noted that like parts-are designated by like reference numerals throughout the accompanying drawings.

### First Embodiment

A component feed method, a component feeding apparatus, a component mounting method, and a component mounting apparatus according to a first embodiment of the present invention will be discussed with reference to the drawings.

The first embodiment will be described on the basis of the component mounting apparatus 201 which is equipped with the component feeding apparatus so as to execute the component mounting method including the component feed method. The component mounting apparatus 201 is schematically formed in the same constitution except the control part 12 as the component mounting apparatus of a high-speed type shown in Fig. 10 of the prior art, and therefore will be described with reference to this Fig. 10. Parts of the same function as in the prior art are denoted by the same reference numerals.

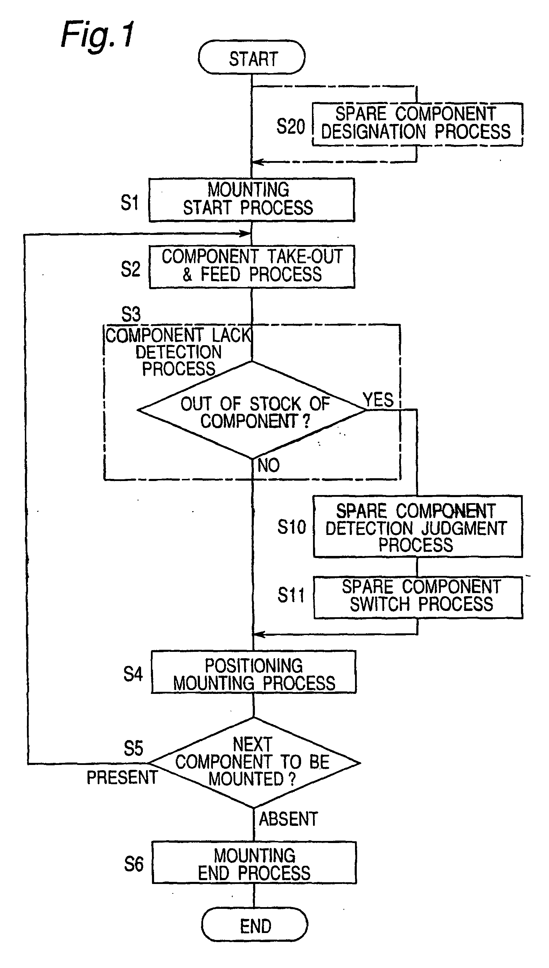

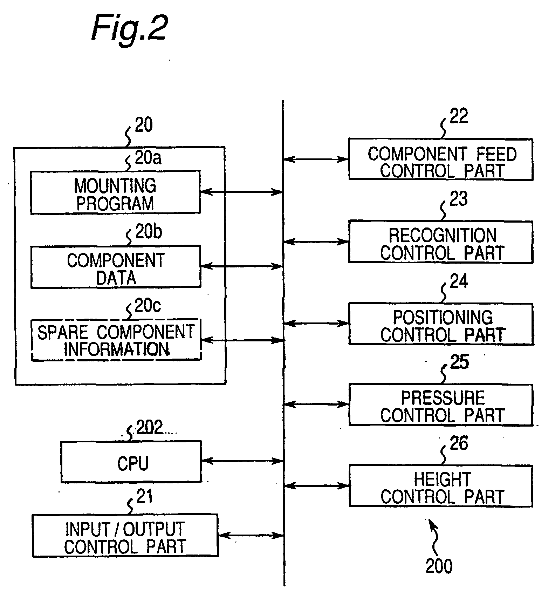

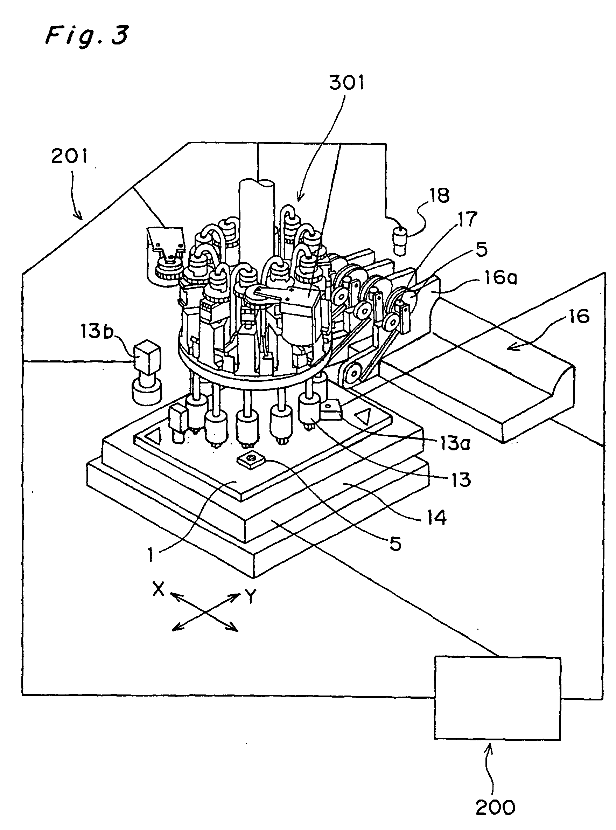

Fig. 1 is a flow chart showing the component mounting method including the component feed method according to the first embodiment of the present invention. Fig. 2 is a block diagram schematically showing a mounting control part 200 of the component mounting apparatus 201 which replaces the-control part 12. In Fig. 2, reference numeral 20 is a memory part, and reference numeral 20a is a mounting program stored in the memory part 20. Reference numeral 20b is component data stored in the memory part 20 and showing component arrangement data consisting of component arrangement positions at a component feed part 16. Reference numeral 20c is spare component information having spare component data such as types of spare components, or properties of spare components, or types and properties and arrangement positions of spare components, etc. written in the memory part 20. Reference numeral 21 is an input/output control part for controlling inputs and outputs of information and signals from external devices or members to the memory part 20 and control parts 22-26 described below. Reference numeral 22 is a component feed control part for functioning as an example of a spare component detection means and for controlling supply of components 5 from parts cassettes 16a and the like of the component feed part 16, and component lack detection, etc. Reference numeral 23 is a recognition control part for controlling recognition of positions and attitudes of the components 5 sucked and held at a plurality of mounting heads 13 supported by a rotary head for rotating to pass a component feed position where the components are supplied from the parts cassettes 16a or the like of the component feed part 16 and a component mounting position where the components are mounted to boards 1. Reference numeral 24 is a positioning control part for controlling positioning of the components 5 sucked and held at the mounting heads 13 to the boards 1 with correcting the positions and attitudes of the components 5 based on the recognition result performed by the recognition control part 25. Reference numeral 25 is a pressure control part for controlling a press force of the mounting heads 13 when pressing thereby mounting the components 5 to the boards 1 when the components sucked and held by the mounting head 13 is mounted onto the board 1. Reference numeral 26 is a height control part for controlling a height of a movement area of the mounting heads 13 to the boards 1 with taking detected heights of components already mounted to the boards 1 into consideration when the heights of the components 5 sucked and held by the mounting heads 13 are detected and then the components are mounted to the boards 1. Reference numeral 202 is a CPU for controlling operations of each driving part of the component mounting apparatus 201, information read and write operations to the memory part 20, operations of the control parts 21-26, etc. As indicated also in Fig. 3, the mounting control part 200 is connected to the rotary head 301, the mounting heads 13, the component feed part 16, a board recognition device 13a, a component inspection part 13b, a mounting table 14, a component information detection part 18, and the like, with controlling not only operations related to detection and judgment and switching of spare components to be detailed later, but also the whole mounting operation.

As shown in Fig. 3, in the constitution of the component mounting apparatus 201 of the first embodiment, the above mounting control part 200 replaces the control part 12 in the component mounting apparatus 10 of a high-speed type of Fig. 10.

In the component mounting apparatus 201 according to the first embodiment, electronic components 5 are mounted to the printed boards 1 on the basis of the mounting program 20a under the control of the mounting control part 200. Then, parts cassettes 16a of the component feed part 16 hold therein components 5 to be mounted for each type or for each characteristic to fit the mounting program 20a or component arrangement data of the component data 20b. The parts cassettes 16a are arranged side by side at the component feed part 16. The necessary component 5 at each time is supplied on the basis of the mounting program 20a from a predetermined one of the parts cassettes 16a to the mounting head 13. The mounting head 13 in turns holds the supplied component and mounts to a predetermined mounting position of the printed board 1.

The operation of the component mounting apparatus 201 in the above constitution will be described on the basis of the flow chart of Fig. 1.

At the start of production of printed boards 1 by the component mounting apparatus 201, under the control of the CPU 202, respective control parts 21-26 of the mounting control part 200 of Fig. 2 of the component mounting apparatus 201 and mechanical driving parts of the component mounting apparatus 201 are initialized at a mounting start process of step S1 in Fig. 1. In the meantime, the printed board 10 is set to the mounting table 14.

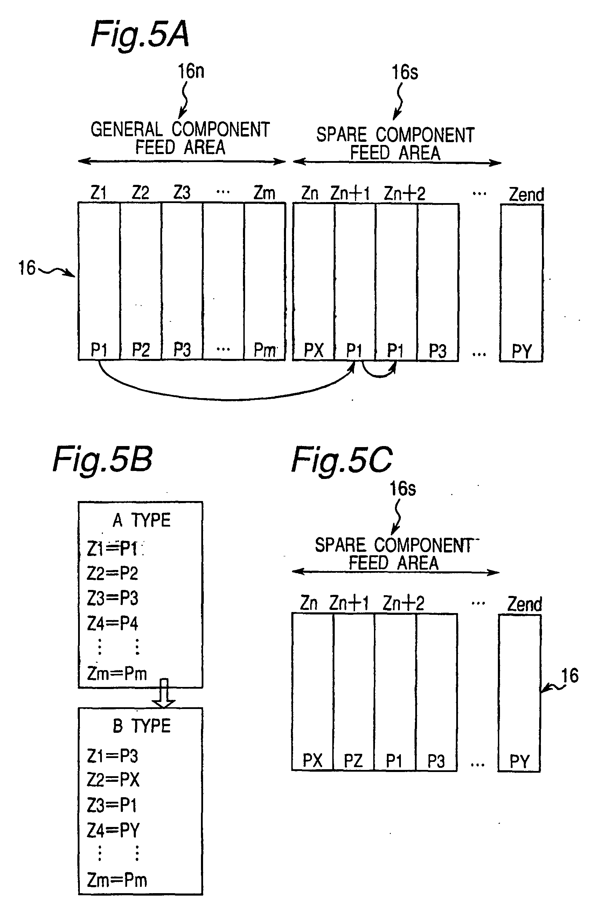

Next, at a component take-out and feed process in step S2 in Fig. 1, the CPU 202 reads out the component arrangement information in the mounting program 20a and in the component arrangement data of the component data 20b of the memory part 20, for example, Z1=P1, Z2=P2, Z3=P3, ..., Zm=Pm for A-type boards 1 and Z1=P3, Z2=PX, Z3=P1, Z4=PY, ..., Zm=Pm for B-type boards 1, as shown in Fig. 5B wherein P1-Pm are types of components 5 and Zl-Zm are arrangement positions of the parts cassettes 16a at the component feed part 16, that is, arrangement positions of components 5 of respective type.

Next, under the control of the CPU 202, the component feed control part 22, with judging the presence/absence of a component lack in a component lack detection process of step S3 of Fig. 1, takes out the component 5 from the component feed part 16. In other words, in accordance with mounting information of the mounting program 20a, the component feed control part 22 obtains information on the types, arrangement positions, etc., of the components 5 to be mounted to the board 1 by the mounting head 13, and judges whether or not each of the components 5 to be mounted is stored in the parts cassette 16a set at the designated component arrangement position in the component feed part 16. If the component 5 to be mounted is present and stored in the designated parts cassette 16a, the process proceeds to a next process.

In a positioning and mounting process of step S4 in Fig. 1, the parts cassette 16a which is designated at step S3 and is judged not to lack the component is slid to a component feed position of the mounting head 13, where the desired component 5 is sucked and held by the mounting head 13. While the component 5 is suitably controlled by the positioning control part 24 and other control parts (for instance, controlled by the positioning control part 24 to be moved to the mounting position while being prevented by the height control part from colliding with other components, and being corrected in position and attitude to be mounted to the mounting position), the component 5 is accurately positioned and mounted by the mounting head 13 under the control of the CPU 202 to the mounting position designated by the mounting program 20a or the like at the printed board 1 on the mounting table 14 designated by the mounting program 20a or the like.

At step S5 of Fig. 1, the CPU 202 judges based on the mounting program 20a whether or not another component 5 to be mounted to the same board 1 remains. The CPU 202 repeats the procedures from step S2 to step S4 until one sheet of the printed board 1 is completely finished. When the mounting operation is completed, a mounting end process is carried out at step S6 of Fig. 1. The finished board 1 is carried out of the mounting table 14 while the CPU 202 performs the board carrying-out control.

In the component lack detection process at step S3 in Fig. 1, if the component feed control part 22 judges that a component of the same type as the component 5 to be mounted is absent in the component data 20b, in other words, as shown in Fig. 5, if, for example, the Pi-type component arranged at component arrangement position Z1 on a left end of the component feed part 16, is absent, the spare component detection judgment process (S10) and the spare component switch process (S11) which characterize the component mounting method of the first embodiment (named as "a free alternate" operation) are adopted, which will be detailed hereinbelow. Specifically, in the free alternate operation, there is a known means, as a component detecting means, for reading by a reading means a memory means installed in the component feed part, equipped with the memory means such as bar code or the like storing types of components as is disclosed in Japanese Unexamined Patent Publication No. 4-164398, etc. in the spare component detection judgment process of step S10 of Fig. 1, thereby obtaining stored information to detect components. Referring to Fig. 3, for instance, the component information detection part 18 which reads or writes component information to a component information memory 17 such as IC or the like arranged in the parts cassette 16a as one example in the prior art is adapted to set as a spare component feed area 16s, component arrangement positions Zn, Zn+1, Zn+2, ..., Zend other than the component arrangement positions Zl-Zm of a component feed area 16n generally used at the component feed part 16 in the component arrangement data of the mounting program 20a and the component data 20b. Component type informations PX, P1, P1, ..., PY at the component arrangement positions of the spare component feed area 16s are sequentially read out, whether the Pi-type spare component for the component P1 to be mounted next is present or not is judged, and the parts cassette 16a storing the Pi-type spare component is detected within the spare component feed area 16s of the component feed part 16. In a case where the spare component of the type is not detected, the production is once stopped at the component mounting apparatus 201 under the control of the CPU 202 until the operator of the apparatus 201 supplements the Pi-type components to the component feed part 16. On the other hand, when the P1-type spare component for the component P1 to be mounted next is detected at the arrangement position Zn+1 of the spare component feed area 16s, in the spare component switch process of step S11 of Fig. 1, the CPU 202 temporarily stores in the memory part 20 the P1-type spare component at the spare component arrangement-position Zn+1 in the spare component feed area 16s as the spare component information 20c, in place of the Pi-type component at the arrangement position Z1. Thereafter, the component arrangement positions of the component arrangement data of the mounting program 20a and the component data 20b are switched to the spare component arrangement position in the spare component feed area 16s for the lacking P1-type component, so that the production is continued under the switched condition. Later again, if the Pi-type spare component at the component arrangement position Zn+1 runs out, the same procedures at steps S10 and S11 are executed, whereby the Pi-type spare component at the component arrangement position Zn+2 is used to continue the production.

Supposing that the memory part 20 of the component mounting apparatus 201 contains the mounting program 20a for two types, A and B types of boards 1 as indicated in Fig. 5B, after B type boards 1 are started to be subjected to mounting subsequent to the type switch from the A type to B type, even when the Pi-type component at the component arrangement position Z3 for the B type board 1 runs out, the Pi-type spare component at the component arrangement position Zn+1 is detected in the same procedures as in steps S10 and S11 and used in place of the Pi-type component at the component arrangement position Z3 of the B type board 1. Accordingly, the continuous production is ensured irrespective of types of boards to be produced.

Referring to Fig. 5C, during the supply of the Pi-type component 5 by the parts cassette 16a at the component arrangement position Zn+1 of the component feed part 16 to the mounting head 13, even if the component information detection part 18 detects that the spare component at the arrangement position Zn+1 changes to be the type PZ in the halfway due to, for example, the operator's mishandling of components or setting of the wrong spare component for a C type board to be produced next, etc., the component arrangement position Zn+2 can be detected and judged correctly through the procedures similar to steps S10 and S11 as the spare component at the component arrangement position Z3 for the Pi-type component. Wherever the spare components are arranged, therefore, the arrangement positions can be surely searched through the spare component detection judgment process and the spare component switch process, thus allowing free positional arrangement of the spare components as well as easy exchange of spare components. Moreover, errors in setting components can be prevented and preparation for the next production is prevented from adversely influencing the present production. Quality in setting, etc. is improved.

According to the first embodiment described hereinabove, spare components can be automatically detected from the component feed part 16 where the parts cassettes 16a and parts trays 16d which contain the components are set optionally. Therefore, the need for setting the components at component arrangement positions of the component feed part truly as designated is eliminated, and also the need for forming the mounting program designating spare component information for every type of boards to meet the production of many types, i.e., various types of boards is eliminated. The trouble of switching types of boards to be produced or management work, etc. can be reduced. More specifically, even at the occurrence of component lack in the component mounting apparatus 201, whether or not spare components are present in the component feed part 16 is automatically detected without interrupting the production, and the spare components detected are used to continue the production, thereby improving productivity. Components set at the component feed part 16 are used as spare components only when the components which types are detected are judged to agree with the type to be mounted. Generation of failures resulting from wrong supplement or wrong setting of components is effectively prevented, and product quality is improved.

The spare component feed area 16s may not be fixed in position in the component feed part 16, but the entire component feed part 16 may be allotted as the spare component feed area 16s. Or the component feed part 16 is divided to a plurality of blocks and one block thereof including a specified number of arrangement units or some blocks are assigned as the spare component feed area 16s, or the component arrangement positions Zn-Zend which are part of the component arrangement positions Z1-Zend of the component feed part 16 can be designated as the spare component feed area 16s. Since the spare component feed area 16s can be freely set in the component feed part 16, more preferable and more flexible free alternate operation is realized.

The spare component information 20c is not limited to data stored different from the component arrangement data of the mounting program 20a or the component data 20b, and can be one information included in the mounting program 20a or component arrangement data of the component data 20b.

### Second Embodiment

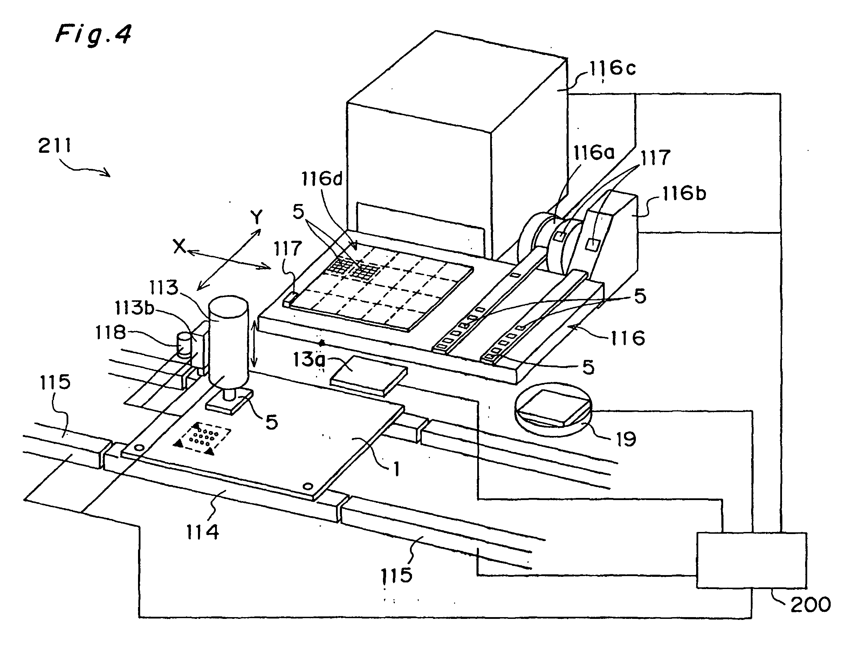

A component feed method, a component feeding apparatus, a component mounting method, and a component mounting apparatus according to a second embodiment of the present invention will be described with reference to Fig. 4.

A component mounting apparatus 211 equipped with the component feeding apparatus so that the component mounting method including the component feed method (free alternate operation) can be carried out will be discussed as the second embodiment of the present invention. As shown in Fig. 4, the component mounting apparatus 211 is schematically constituted of the conventional component mounting apparatus 110 of a multi-functional middle-speed type shown in Fig. 11, with having the mounting control part 200 in Fig. 2 instead of the control part 112. This mounting control part 200 alike is connected, as is clear from Fig. 4, to an XY robot 300, a mounting head 113, a component feed part 116, a board recognition device 113a, a component inspection part 113b, a mounting table 114, a component information detection part 118, etc., thereby controlling not only the operation at the time of the spare component detection judgment and switching, but the whole mounting operation. In the second embodiment, the spare component detection judgment process and the spare component switch process almost similar to the first embodiment are conducted. Operations and parts similar to the first embodiment or the conventional example are denoted by the same reference numerals as in the first embodiment or conventional example, and the description thereof will be omitted.

A difference of the second embodiment from the first embodiment is a manner of how to input component information. The component information detection part 118 of the component mounting apparatus 211 is arranged at a side part of the board recognition part 113b fixed to a side part of the mounting head 113 which can be moved by the XY robot 300 in an X direction and a Y direction orthogonal to the X direction. Component type information, etc., stored in component information memories 117 such as ICs or the like at parts cassettes 116a, a bulk cassette 116b, and parts trays 116d taken out from a parts tray container part 116c of the component feed part 16 can be detected by the component information detection part 118. In contrast to the first embodiment wherein the component information in the component data 20b or the spare component information 20c stored beforehand in the memory part 20 is utilized to detect spare components within the component feed part 16, the component information is not stored preliminarily according to this second embodiment, and the mounting head 113 is moved to detect the component type information, etc. stored in the component information memory 117 such as IC or the like of the parts cassette 116a, bulk cassette 116b, parts tray 116d taken out from the parts tray container part 116c of the component feed part 116 by the component information detection part 118 fixed to the mounting head 113. The detected information is then stored as the component data 20b or the spare component information 20c in the memory part 20 via the input/output control part 21. The complicate work of manually storing the component type information into the memory part 20 as the component data 20b or the spare component information 20c is eliminated. The second embodiment is an application of the first embodiment to the mounting apparatus of a multi-functional type adapted to receive components also from trays, etc., with exerting the same effect and action as the first embodiment. Each of the parts cassette 116a, bulk cassette 116b, parts tray 116d taken out from the parts tray container part 116c of the component feed part 116 is provided with the information memory according to the second embodiment and therefore components can be mounted more correctly.

A two-dimensional bar code or known QR code (quick response code of a matrix expressing numbers or characters in a machine readable form by a combination of cells (points) and spaces) may be applied as the component information memory 117 to each component, e.g., QFP or CSP integrated circuit or semiconductor component. The board recognition part 113b may be used as the component information detection part 118 to read the information.

### Third Embodiment

A component feed method, a component feeding apparatus, a component mounting method, and a component mounting apparatus according to a third embodiment of the present invention will be described with reference to the drawings.

In the third embodiment of the present invention, a spare component designation process (step S20 indicated by a chain line in Fig. 1) is additionally provided in the component mounting apparatus 201, 211 which includes the component feeding apparatus so that the component mounting method with the component feed method (free alternate operation) can be executed.

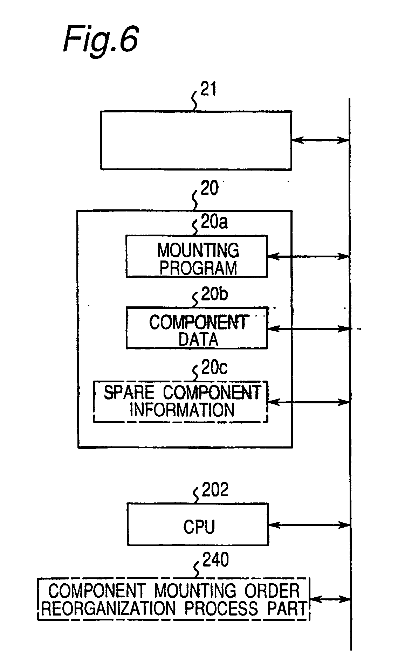

Fig. 6 is a schematic diagram showing the constitution for the spare component designation process S20 in the component feed method and component feeding apparatus carried out in the component mounting method and component mounting apparatus according to the third embodiment of the present invention.

In the component mounting method and component mounting apparatus of the third embodiment, conditions such as various operation modes in the free alternate operation described later, whether or not the free alternate operation is carried out, etc., can be set under the control of the input/output control part 21 of the mounting control part 200 through an operation part 11 or 111 having a keyboard and the like of the component mounting apparatus 201 in Fig. 10 or the component mounting apparatus 211 in Fig. 11.

As a concrete example of the conditions, how to handle the spare component information, whether the spare component information is to be detected and judged beforehand or at each time, etc. are set as described below. Every time the component lack occurs in the first and second embodiments, spare components are detected and the detected information is stored as the spare component information 20c into the memory part 20, based on which-the spare component detection judgment process (step S10 in Fig. 1) of judging whether the components can be used as spare components is executed. On the other hand, in the spare component designation process S20 in the third embodiment prior to the mounting start process at step S1 of Fig. 1, component arrangement states of all spare components at the component feed part 16 are read out by the component feed control part 22 which is an example of the spare component detection means. The read information is registered beforehand as a spare component information 20d in the memory part 20. For instance, in the case of the component feed part 16 in Fig. 5A, such information is stored as the spare component information 20d that informs that the P1-type component is found at the component arrangement position Zn+1 when the Pi-type component at the component arrangement position Z1 is absent, and the P-type component is present at the arrangement position Zn+2 when the component is absent at the component arrangement position Zn+1.

In the execution of the spare component detection judgment process (step S10 of Fig. 1) at the occurrence of the component lack, simply searching and judging data of the spare component information 20d in the memory part 20 enables immediate detection of the component arrangement positions of spare components. Accordingly, at every component lack, the detection judgment process of reading out the entire information of the component arrangement positions of the spare component feed area 16s of the component feed part 16 from the component data 20b by the component feed control part 22 thereby detecting and judging whether replaceable spare components are present or not, etc., and an extra process, for example, of moving and positioning the component information detection part 18 to each parts cassette 16a, etc. and reading out information of component names from the parts cassettes 16a, etc. can be eliminated together with a loss time. Productivity can be furthermore improved.

If information of subject spare components is adapted to be directly input as the spare component information 20d via the keyboard into the memory part 20 under the control of the input/output control part 21 through the operation part 11, 111 in the spare component designation process (step S20 represented by the chain line in Fig. 1) in the third embodiment of the present invention, and if data of a relationship between types and component arrangement positions of spare components is added to the spare component information 20d in the memory part 20 beforehand, procedures are similarly carried out as according to -the above embodiments, so that the free alternate operation is realized even if the component feed control part 22 in charge of the spare component detection judgment process fails.

The spare component designation process of the third embodiment (step S20 indicated by the chain line in Fig. 1) thus enables the information 20d of subject spare components to be directly input from the operation part 11, 111 to form the spare component information 20d even in the absence of the component feed control part 22 as the spare component detection means in the conventional component mounting apparatus 10, 110 of Fig. 10, 11. The free alternate operation is thus achieved similarly.

According to the third embodiment, components to be used in common in various types of boards are registered beforehand as the spare component information 20d. Therefore, when types of boards to be produced are switched, types of components to be mounted are detected from the registered component types in the component feed part 16 and thus, the presence/absence of the spare components can be judged efficiently. It is not necessary to detect spare components from the component feed part 16 at each time of component lack. Since spare components can be exchanged in the shortened process of the equipment at the occurrence of component lack, productivity can be improved further.

### Fourth Embodiment

A component feed method and a component feeding apparatus used in a component mounting method and a component mounting apparatus in a fourth embodiment of the present invention features a spare component switch process (step S11A). As shown in Fig. 7, in the spare component switch process, a component mounting order reorganization process in step S12 of Fig. 7 is performed at a component mounting order reorganization process part 240 indicated by a chain line in Fig. 6 after the spare component switch process of step S11 of Fig. 1 is carried out.

Generally in mounting components, components 5 are taken out from the component feed part 16 by the mounting heads 13 and mounted to the printed boards 1. In the component mounting apparatus 201 in which the parts cassettes 16a of the component feed part 16, etc. slide as shown in Figs. 3 and 10, in the case where it is necessary for the mounting head 13 after taking out the spare component, to move a long distance via the XY robot to a take-out position to take out the next component as indicated by the mounting program 20a in the execution of the free alternate operation, the operation if carried out according to the mounting order as indicated by the original mounting program before the component is switched to the spare component would produce a waste. A production time per one board, that is, a mounting cycle time is greatly deteriorated thereby lowering productivity. As such, when a difference of the movement distances of the mounting head 13 before and after the spare component is switched at step S11 is not smaller than a predetermined threshold value, the component mounting order reorganization process (step S12 in Fig. 7) is carried out by the component mounting order reorganization process part 240 as shown by the chain line in Fig. 6. The component mounting order is reorganized and the mounting program 20a is rewritten so that the mounting head 13 can move a shorter distance between the mounting position and component feed position. Even when the component arrangement position is changed because of the spare component switch process (step S11 of Fig. 7), a suitable component mounting order matching a feed state of the component feed part 16 is calculated not to decrease the mounting cycle time and productivity and, then, the mounting program 20a is automatically regenerated. The production can be continued accordingly.

### Fifth Embodiment

According to a component feed method and a component feeding apparatus used in a component mounting method and a component mounting apparatus in a fifth embodiment of the present invention, the entire component feed part 16, 116 is treated as the spare component feed area 16s to produce optional types of boards 1 in the mounting apparatus 201 of Fig. 3, mounting apparatus 211 of Fig. 4. At the production start process (step S1 of Fig. 1), the component feed control part 22 detects information of component types, component arrangement positions, etc. of the whole of the component feed part 16, 116, so that component arrangement data of the component data 20b of the component feed control part 22 to be used by the mounting program 20a is automatically generated for production. In this case, it is enough to read only the component arrangement data in the spare component detection judgment process. If a plurality of the same components are detected, these may be stored in the spare component information.

In the constitution, components can be mounted correctly without the operator's awareness of a set position of the parts cassettes 16a or 116a to the component feed part 16, 116 (referred to as a "free layout production"). Furthermore, highly productive and high-quality production is enabled in association with the component mounting order reorganization process described in the fourth embodiment (step S12 of Fig. 7).

The present invention is not limited to the foregoing embodiments and can be embodied in various forms. For example, although the component detection means is constituted of the component information memory 17 and component information detection part 18 in the above description of the embodiments, the other kinds of sensors or any other means that can judge types of components, e.g., ID code or the like can be used.

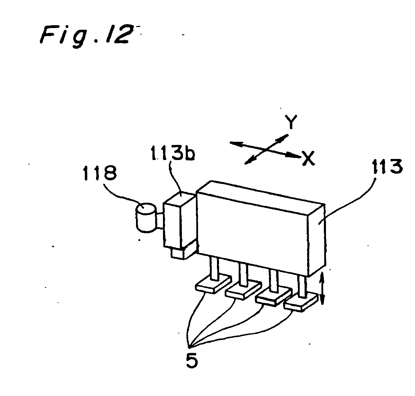

In the second embodiment, the mounting head 113 described holds one component 5. However, the mounting head 113 may be equipped with multi nozzles to hold a plurality of, e.g., four in Fig. 12, components 5 or two or more mounting heads 113 can be set in the mounting apparatus.

The component arrangement data of the component data 20b is containable in the mounting program 20a.

The spare component is not necessarily a substitute of the same type. A substitute of the same characteristic or even a substitute manufactured by a different maker and having a different characteristic (e.g., temperature characteristic) which matters little is utilizable. In that case, whether the spare component is proper or not is judged on the basis of the component characteristic or the like, not the component type as above, and information of the component characteristic or the like is stored for the purpose. Also information of both the component type and the component characteristic can be used to make the judgment.

According to the component feed method, component feeding apparatus, component mounting method, and component mounting apparatus in one mode of the present invention, as described above, spare components can be automatically detected from the component feed part where parts cassettes, parts trays, etc., holding components are set optionally. The need of setting components to the component arrangement positions of the component feed part as designated is eliminated. Moreover, the need of forming the mounting program for designating the spare component information for every type of various boards to be produced is eliminated. Preparation and management work for the switching of production types is reduced. Concretely, spare components are detected within the component feed part and whether the spare components are set in the component feed part is automatically judged without interrupting the production and decreasing the mounting cycle time or productivity even in the occurrence of component lack. With the spare components detected to be present in the component feed part, the spare components are utilized to continue the production, so that productivity is improved. In a case where the types or characteristics of spare components set in the component feed part are detected, only when the spare components set in the component feed part are judged to fit the type or characteristic to be mounted, the spare components are used, and therefore failures resulting from wrong setting or wrong supplement of components can be avoided and product quality can be improved.

The spare component feed area in the component feed part may not be fixed in position. The whole component feed part can be allotted as the spare component feed area, or the component feed part may be divided to a plurality of blocks all of or one of or some of which are respectively employed as the spare component feed areas. Also a further idea is conceivable, whereby the component arrangement positions as part of the component arrangement positions in the component feed part may be designated as the spare component feed area. Since the spare component feed area can be freely set at the component feed part, more favorable and more flexible free alternate operation is realized.

In the other mode of the present invention, components to be used in common among various types of boards are registered as spare component information beforehand. In switching the types of boards, the type or characteristic of components to be mounted is detected from the registered type or characteristic of components in the component feed part, thus enabling effective judgment on the presence/absence of spare components. The detection of spare components from the component feed part is not necessary for each time of component lack. The switching can be handled in a shorter time inline to cope with the component lack, and productivity can be improved furthermore.

According to the present invention in the different mode, after the spare components are automatically switched in the spare component switch process due to the component lack, the mounting order matching the switched feed state for the spare components is operated and the mounting program is regenerated in the component mounting order reorganization process. Thus, highly productive and high-quality production can be performed.

Moreover, in the further different mode of the present invention, because of automatically detecting spare components from the component feed part set optionally, the need of setting the subject spare components to the component feed position of the component feed part as designated is eliminated. The mounting program for designating the spare component information for each type of boards is not required to be formed even when various types of boards are to be produced. Preparation, management work, etc. for the switching can be reduced effectively.

The feed position of spare components of types or characteristics is detected from the component feed part, so that wrong production because of wrong setting of spare components can be prevented.

## Claims

1. A component feed method wherein a component (5) is supplied from a component arrangement position at a componenr feed part (16, 116) designated by a mounting program when the component is mounted to a mounting position on a printed board (1) based on the mounting program,
said method including:
a component lack detection process (S3) of detecting a lack of the component to be mounted which is designated by the mounting program at the component arrangement position of the component feed part;
a spare component detection judgment process (S10) of detecting whether or not a spare component for the lacking component to be mounted is loaded in a spare component feed area (16s) of the component feed part and judging whether or not
the spare component is located within the spare component feed area; and
a spare component switch process (S11) of switching the supply of the component to be mounted from the designated component arrangement position of the component feed part to the supply of the spare component from the spare component feed area when the spare component is judged to be present in the spare component feed area at the spare component detection judgment process.

2. A component feed method according to claim 1, wherein the spare component feed area (16s) at the component feed part in the spare component detection judgment process (S10) is an area other than a component feed area (16n) whereat the component supply is designated in the mounting program designed for mounting the component to the printed board of an optional type, so that the supply of the component to be mounted from the component feed area at the component feed part is switched in the spare component switch process (S11) to the supply of the spare component from the spare component feed area when the spare component is judged to be present in the spare component feed area in the spare component detection judgment process.

3. A component feed method according to claim 1, wherein the spare component feed area (16s) at the component feed part in the spare component detection judgment process (S10) is an area overlapping with a component feed area (16n) whereat the component supply is designated in the mounting program designed for mounting the component to the printed board of an optional type, so that the supply of the component to be mounted from the component feed area at the component feed part is switched in the spare component switch process (S11) to the supply of the spare component from the spare component feed area when the spare component is judged to be present in the spare component feed area in the spare component detection judgment process.

4. A component feed method according to any one of claims 1-3, wherein whether or not the spare component for the lacking component to be mounted is loaded in the spare component feed area (16s) of the component feed part is detected in the spare component detection judgment process (S10) within a component data (20b) which stores beforehand information on types or characteristics, and arrangement positions of components arranged in the spare componenet feed area of the component feed part, thereby judging whether or not the spare component is present in the spare component feed area.

5. A component feed method according to any one of claims 1-3, which includes prior to the spare component detection judgment process a spare component designation process (S20) of preliminarily designating, and registering a component arrangement position of the spare component at the component feed part which can replace the component to be mounted if the component feed part lacks the component, while in the spare component detection judgment process the spare component corresponding to the lacking component to be mounted is detected from spare components at the component feed part designated and registered in the spare component designation process, thereby judging presence/absence of the spare component corresponding to the lacking component to be mounted.

6. A component mounting method including a component feed method according to any one of claims 1-5, which includes a component mounting order reorganization process (S12) wherein after the spare component is automatically switched in the spare component switch process (S11) a mounting order is operated in conformity with a component feed state switched for the spare component, thereby re-generating the mounting program.

7. A component mounting apparatus which takes out a component (5) from a component arrangement position designated by a mounting program of a component feed part (16, 116) on the basis of the mounting program and mounts the component to a mounting position on a printed board (1),
said apparatus comprising:
a component lack detection means (202, 22) for detecting a lack of the component to be mounted at the component arrangement position of the component feed part designated by the mounting program;
a spare component detection judgment means (202, 22) for detecting whether or not a spare component for the lacking component to be mounted is loaded in a spare component feed area (16s) of the component feed part, and judging whether or not the spare component is located within the spare component feed area; and
a spare component switch means (202, 22) for switching supply of the component to be mounted from the designated component arrangement position of the component feed part to supply of the spare component from the spare component feed area when the spare component is judged to be present within the spare component feed area by the spare component detection judgment means.

8. A component mounting apparatus according to claim 7, wherein the spare component feed area (16s) of the component feed part judged by the spare component detection judgment means (202, 22) is an area other than a component feed area (16n) whereat the component supply is designated in the mounting program designed for mounting the component to the printed board of an optional type, so that the supply of the component to be mounted from the component feed are a of the component feed part is switched by the spare component switch means (202, 22) to the supply of the spare component from the spare component feed area when the spare component is judged to be present in the spare component feed area by the spare component detection judgment means.

9. A component mounting apparatus according to claim 7, wherein the spare component feed area (16s) of the component feed part judged by the spare component detection judgment means (202, 22) is an area overlapping with a component feed area (16n) whereat the component supply is designated in the mounting program designed for mounting the component to the printed board of an optional type, so that the supply of the component to be mounted from the component feed area of the component feed part is switched by the spare component switch means (202, 22) to the supply of the spare component from the spare component feed area when the spare component is judged to be present in the spare component feed area by the spare component detection judgment means.

10. A component mounting apparatus according to any one of claims 7-9, wherein whether or not the spare component for the lacking component to be mounted is loaded in the spare component feed area (16s) of the component feed part is detected by the spare component detection judgment means (202, 22) within a component data (20b) which stores beforehand information on types or characteristics and arrangement positions of components arranged in the spare component feed area of the component feed part, thereby judging whether or not the spare component is present in the spare component feed area.

11. A component mounting apparatus according to any one of claims 7-9, which comprises a spare component designation means (21) for preliminarily designating and registering, prior to the spare component detection judgment, a component arrangement position of the spare component at the component feed part which can replace the component to be mounted if the component feed part lacks the component, while the spare component detection judgment means detects the spare component corresponding to the lacking component to be mounted from spare components at the component feed part designated and registered by the spare component designation means, thereby judging the presence/absence of the spare component corresponding to the lacking component to be mounted.

12. A component mounting apparatus according to any one of claims 7-11, which includes a component mounting order reorganization means (240) for, after the spare component is automatically switched by the spare component switch means (202, 22) operating a mounting order in conformity with a component feed state switched for the spare component, and thereby re-generating the mounting program.

## Patentansprüche

1. Ein Verfahren zur Bauteilzuführung, bei dem ein Bauteil (5) aus einer Bauteilversorgungsposition zu einem Bauteilzuführungsabschnitt (16, 116), der durch ein Montageprogramm bestimmt wurde, zugeführt wird, wenn das Bauteil in eine Montageposition auf einer gedruckten Schaltung (1), basierend auf dem Montageprogramm, montiert wird, umfassend:
einen Bauteilmangelerfassungsvorgang (S3) zum Bestimmen eines Mangels des zu montierenden Bauteils, welches durch das Montageprogramm an der Bauteilversorgungsposition des Bauteilzuführabschnitts bestimmt wurde;
einen Ersatzbauteilerfassungs- und Entscheidungsvorgang (S10) zum Erfassen ob, oder ob nicht ein Ersatzbauteil für das fehlende, zu montierende Bauteil in einen Ersatzbauteilzuführungsabschnitt (16s) des Bauteilzuführungsabschnitts geladen wird und zum Entscheiden, ob oder ob nicht das Ersatzbauteil innerhalb des Ersatzbauteilzuführungsbereichs angeordnet ist; und
einen Ersatzbauteilschaltvorgang (S11) um die Zufuhr der zu montierenden Bauteile von der vorbestimmten Bauteilversorgungsposition des Bauteilzuführungsabschnitts zu der Zuführung des Ersatzbauteils aus dem Ersatzbauteilzuführungsbereich zu schalten, wenn bei dem Ersatzbauteilerfassungs- und Entscheidungsvorgang entschieden wird, dass das Ersatzbauteil in dem Ersatzbauteilzuführungsbereich vorhanden ist.

2. Verfahren nach Anspruch 1,
bei dem der Ersatzbauteilzuführungsbereich (16s) bei dem Bauteilzuführungsabschnitt in dem Ersatzbauteilerfassungs- und Entscheidungsvorgang (S10) ein anderer Bereich ist als ein Bauteilzuführungsbereich (16n), auf den die Bauteilzuführung in dem Montageprogramm bestimmt ist, welches zur Montage der Bauteile auf die gedruckte Schaltung einer beliebigen Art ausgebildet ist, so dass in dem Ersatzbauteilschaltvorgang (S11) die Zuführung der zu montierenden Bauteile von dem Bauteilzuführungsbereich an dem Bauteilzuführungsabschnitt in die Zuführung des Ersatzbauteils aus dem Ersatzbauteilzuführungsbereich geschaltet wird, wenn in dem Ersatzbauteilerfassungs- und Entscheidungsvorgang entschieden wird, dass das Ersatzbauteil in dem Ersatzbauteilzuführungsbereich vorhanden ist.

3. Verfahren nach Anspruch 1,
bei dem der Ersatzbauteilzuführungsbereich (16s) an dem Bauteilzuführungsabschnitt im Ersatzbauteilerfassungs- und Entscheidungsvorgang (S10) ein Bereich ist, der mit einem Bauteilzuführungsbereich (16n) überlappt, wobei die Bauteilzuführung in dem Montageprogramm bestimmt wird, welches zur Montage der Bauteile auf die gedruckte Schaltung einer beliebigen Art ausgebildet ist, so dass die Zuführung der zu montierenden Bauteile aus dem Bauteilzuführungsbereich an dem Bauteilzuführungsbereich im Ersatzbauteilschaltvorgang (S11) zu der Zuführung der Ersatzbauteile aus dem Ersatzbauteilzuführungsbereich geschaltet wird, wenn in dem Ersatzbauteilerfassungs- und Entscheidungsvorgang entschieden wird, dass das Ersatzbauteil in dem Ersatzbauteilzuführungsbereich vorhanden ist.

4. Verfahren nach einem der Ansprüche 1 bis 3,
bei dem in dem Ersatzbauteilerfassungs- und Entscheidungsvorgang (S10) erfasst wird, ob oder ob nicht das Ersatzbauteil für das fehlende, zu montierende Bauteil in den Ersatzbauteilzuführungsbereich (16s) des Bauteilzuführungsabschnitts geladen wird, innerhalb eines Bauteildatensatzes (20b), welcher Vorabinformation über Arten oder Eigenschaften und Anordnungspositionen von Bauteilen speichert, welche in dem Ersatzbauteilzuführungsbereich des Bauteilzuführungsabschnitts angeordnet sind, wobei entschieden wird, ob oder ob nicht das Ersatzbauteil in dem Ersatzbauteilzuführungsbereich vorhanden ist.

5. Verfahren nach einem der Ansprüche 1 bis 3,
welches einen dem Ersatzbauteilerfassungs- und Entscheidungsvorgang vorgeschalteten Ersatzbauteilbestimmungsvorgang (S20) beinhaltet zum vorherigen Bestimmen und Erfassen einer Bauteilanordnungsposition des Ersatzbauteils an dem Bauteilzuführungsabschnitt, welches das zu montierende Bauteil ersetzen kann, wenn dem Bauteilzuführabschnitt das Bauteil fehlt, während in dem Ersatzbauteilerfassungs- und Entscheidungsvorgang das dem fehlenden, zu montierenden Bauteil entsprechende Ersatzbauteil aus Ersatzbauteilen an dem Bauteilzuführungsabschnitt bestimmt wird, welcher in dem Ersatzbauteilbestimmungsvorgang bestimmt und erfasst wurde, wobei über das Vorhandensein/Nichtvorhandensein des dem fehlenden, zu montierenden Bauteil entsprechenden Ersatzbauteil entschieden wird.

6. Bauteilmontageverfahren, beinhaltend ein Bauteilzuführungsverfahren nach einem der Ansprüche 1 bis 5,
beinhaltend einen Bauteilmontagereihenfolgen- und Reorganisationsvorgang (S12) bei dem eine Montagereihenfolge in Abstimmung mit einem Bauteilzuführungsstatus, welcher für das Ersatzbauteil geschaltet wurde, betrieben wird, nachdem in dem Ersatzbauteilschaltvorgang (S11) automatisch das Ersatzbauteil geschaltet wurde, wobei das Montageprogramm rückerzeugt wird.

7. Bauteilmontagevorrichtung, welche ein Bauteil (5) aus einer Bauteilversorgungsposition entnimmt, welche durch ein Montageprogramm eines Bauteilzuführungsabschnitts (16, 116) auf der Grundlage des Montageprogramms bestimmt wurde und welche das Bauteil in eine Montageposition auf einer gedruckten Schaltung (1) montiert, umfassend:
Bauteilmangelerfassungsmittel (202, 22) zum Erfassen eines Mangels der zu montierenden Bauteile an der Bauteilversorgungsposition des Bauteilzuführungsabschnitts, welcher durch das Montageprogramm bestimmt wurde;
Ersatzbauteilerfassungs- und Entscheidungsmittel (202, 22) zum Erfassen, ob oder ob nicht ein Ersatzbauteil für das fehlende, zu montierende Bauteil in einen Ersatzbauteilzuführungsbereich (16s) des Bauteilzuführungsbereichs geladen ist, und zum Entscheiden, ob oder ob nicht das Ersatzbauteil innerhalb des Ersatzbauteilzuführungsbereichs angeordnet ist; und
Ersatzbauteilschaltmittel (202, 22) zum Umschalten der Versorgung der aus der vorbestimmten Bauteilzuführungsposition des Bauteilzuführungsabschnitts zu montierenden Bauteile zur Versorgung der Ersatzbauteile aus dem Ersatzbauteilzuführungsbereich, wenn durch die Ersatzbauteilerfassungs- und Entscheidungsmittel entschieden wird, dass das Ersatzbauteil in dem Ersatzbauteilzuführungsbereich vorhanden ist.

8. Vorrichtung nach Anspruch 7,
bei der der Ersatzbauteilzuführungsbereich (16s) des durch die Ersatzbauteil-Erfassungsentscheidungsmittel (202, 22) entschiedenen Bauteilzuführungsabschnitts eine anderer Bereich ist als ein Bauteilzuführungsbereich (16n), zu welchem die Bauteilzuführung durch das Montageprogramm bestimmt ist, welches zur Montage des Bauteils auf die gedruckte Schaltung einer optionaler Art ausgebildet ist, so dass die Zuführung des zu montierenden Bauteils von dem Bauteilzuführungsbereich des Bauteilzuführungsabschnitts durch die Ersatzbauteilschaltmittel (202, 22) zu der Zuführung der Ersatzbauteile aus dem Ersatzbauteilzuführungsbereich geschaltet wird, wenn durch die Ersatzbauteilerfassungs- und Entscheidungsmittel entschieden wird, dass das Ersatzbauteil in dem Ersatzbauteilzuführungsbereich vorhanden ist.

9. Vorrichtung nach Anspruch 7,
bei dem der Ersatzbauteilzuführungsbereich (16s) des durch die Ersatzbauteilerfassungsentscheidungsmittel (202, 22) bestimmten Bauteilzuführungsabschnitts ein Bereich ist, der mit einem Bauteilzuführungsbereich (16n) überlappt, zu dem die Bauteilzuführung durch das Montageprogramm bestimmt ist, welches für die Montage der Bauteile auf eine gedruckte Schaltung einer beliebigen Art ausgebildet ist, so dass die Zuführung der zu montierenden Bauteile aus dem Bauteilzuführungsbereich des Bauteilzuführungsabschnitts durch die Ersatzbauteilschaltmittel (202, 22) auf die Zuführung der Ersatzbauteile aus dem Ersatzbauteilzuführungsbereich geschaltet wird, wenn durch die Ersatzbauteii-Erfassungsentscheidungsmittel entschieden wird, dass das Ersatzbauteil in dem Ersatzbauteilzuführungsbereich vorhanden ist.

10. Vorrichtung nach einem der Ansprüche 7 bis 9,
bei dem durch die Ersatzbauteilerfassungs- und Entscheidungsmittel (202, 22) bestimmt wird, ob oder ob nicht das Ersatzbauteil für das fehlende, zu montierende Bauteil in den Ersatzbauteilzuführungsbereich (16s) des Bauteilzuführungsabschnitts geladen ist, innerhalb eines Bauteildatensatzes (20b), welcher Vorabinformation über Arten oder Eigenschaften und Anordnungspositionen von Bauteilen speichert, welche in dem Ersatzbauteilzuführungsbereich des Bauteilzuführungsabschnitts angeordnet sind, wobei entschieden wird, ob oder ob nicht das Ersatzbauteil in dem Ersatzbauteilzuführungsbereich vorhanden ist.

11. Vorrichtung nach einem der Ansprüche 7 bis 9,
umfassend Ersatzbauteilbestimmungsmittel (21) zur vorherigen, vor der Ersatzbauteil-Erfassungsentscheidung, Bestimmung und Registrierung einer Bauteilanordnungsposition des Ersatzbauteils in dem Bauteilzuführungsabschnitt, welches das zu montierende Bauteil ersetzen kann, wenn dem Bauteilzuführungsabschnitt das Bauteil fehlt, während die Ersatzbauteil-Erfassungsentscheidungsmittel das dem fehlenden, zu montierenden Bauteil entsprechende Ersatzbauteil aus den Ersatzbauteilen in dem Bauteilzuführungsabschnitt, welcher durch die Ersatzbauteilbestimmungsmittel bestimmt und registriert wurde, erfassen, und dabei über das Vorhandensein/Nichtvorhandensein des dem fehlenden, zu montierenden Bauteil entsprechenden Ersatzbauteil entscheiden.

12. Vorrichtung nach einem der Ansprüche 7 bis 11,
beinhaltend Mittel zur Bauteilmontagereihenfolge- und Reorganisation zum Betrieb einer Montagereihenfolge gemäß eines für das Ersatzbauteil geschalteten Bauteilzuführungsstatus, nachdem das Ersatzbauteil automatisch durch die Ersatzbauteilschaltmittel (202, 22) geschaltet wurde, wobei das Montageprogramms rückerzeugt wird.

## Revendications

1. Procédé d'alimentation en composants dans lequel un composant (5) est fourni à partir d'une position d'agencement de composant au niveau d'une partie d'alimentation en composants (16, 116) indiquée par un programme de montage lorsque le composant est monté à une position de montage sur une carte à circuit imprimé (1) sur la base du programme de montage,
ledit procédé comprenant :
un procédé de détection d'absence de composant (S3) consistant à détecter l'absence du composant devant être monté qui est indiquée par le programme de montage au niveau de la position d'agencement de composant de la partie d'alimentation en composants,
un procédé d'évaluation de détection de composant de réserve (S10) consistant à détecter si un composant de réserve pour le composant manquant devant être monté est chargé ou non dans une zone d'alimentation en composants de réserve (16s) de la partie d'alimentation en composants et à évaluer si le composant de réserve est situé ou non à l'intérieur de la zone d'alimentation en composants de réserve, et
un procédé de basculement de composant de réserve (S11) consistant à basculer la fourniture du composant devant être monté depuis la position d'agencement de composant indiquée de la partie d'alimentation en composants vers la fourniture du composant de réserve provenant de la zone d'alimentation en composants de réserve lorsque le composant de réserve est évalué comme étant présent dans la zone d'alimentation en composants de réserve au cours du procédé d'évaluation de détection de composant de réserve.

2. Procédé d'alimentation en composants selon la revendication 1, dans lequel la zone d'alimentation en composants de réserve (16s), au niveau de la partie d'alimentation en composants, lors du procédé d'évaluation de détection de composant de réserve (S10), est une zone autre qu'une zone d'alimentation en composants (16n) au niveau de laquelle la fourniture de composants est indiquée dans le programme de montage conçu en vue de monter le composant sur la carte à circuit imprimé d'un type optionnel, de sorte que la fourniture du composant devant être monté provenant de la zone d'alimentation en composants au niveau de la partie d'alimentation en composants, est basculée au cours du procédé de basculement de composant de réserve (S11) vers la fourniture du composant de réserve provenant de la zone d'alimentation en composants de réserve lorsque le composant de réserve est évalué comme étant présent dans la zone d'alimentation en composants de réserve au cours du procédé d'évaluation de détection de composant de réserve.

3. Procédé d'alimentation en composants selon la revendication 1, dans lequel la zone d'alimentation en composants de réserve (16s), au niveau de la partie d'alimentation en composants, lors du procédé d'évaluation de détection de composant de réserve (S10), est une zone en chevauchement avec une zone d'alimentation en composants (16n) au niveau de laquelle la fourniture de composants est indiquée dans le programme de montage conçu en vue de monter le composant sur la carte à circuit imprimé d'un type optionnel, de sorte que la fourniture du composant devant être monté provenant de la zone d'alimentation en composants au niveau de la partie d'alimentation en composants, est basculée au cours du procédé de basculement de composant de réserve (S11) vers la fourniture du composant de réserve provenant de la zone d'alimentation en composants de réserve lorsque le composant de réserve est évalué comme étant présent dans la zone d'alimentation en composants de réserve au cours du procédé d'évaluation de détection de. composant de réserve.

4. Procédé d'alimentation en composants selon l'une quelconque des revendications 1 à 3, dans lequel le fait que le composant de réserve pour le composant manquant devant être monté soit chargé ou non dans la zone d'alimentation en composants de réserve (16s) de la partie d'alimentation en composants, est détecté au cours du procédé d'évaluation de détection de composant de réserve (S10), à l'intérieur de données de composants (20b) qui mémorisent au préalable des informations sur les types ou les caractéristiques et les positions d'agencement des composants agencés dans la zone d'alimentation en composants de réserve de la partie d'alimentation en composants, en évaluant ainsi si le composant de réserve est présent ou non dans la zone d'alimentation en composants de réserve.

5. Procédé d'alimentation en composants selon l'une quelconque des revendications 1 à 3, qui comprend avant le procédé d'évaluation de détection de composant de réserve, un procédé de désignation de composant de réserve (S20) consistant à désigner de façon préliminaire, et à enregistrer une position d'agencement de composant du composant de réserve au niveau de la partie d'alimentation en composants qui peut remplacer le composant devant être monté si la partie d'alimentation en composants est dénuée du composant, tandis que lors du procédé d'évaluation de détection de composant de réserve le composant de réserve correspondant au composant manquant devant être monté est détecté à partir de composants de réserve au niveau de la partie d'alimentation en composants désignée et enregistrée au cours du procédé de désignation de composant de réserve, en évaluant ainsi la présence/l'absence du composant de réserve correspondant au composant manquant devant être monté.

6. Procédé de montage de composants comprenant un procédé d'alimentation en composants selon l'une quelconque des revendications 1 à 5, qui comprend un procédé de réorganisation d'ordre de montage de composants (S12) dans lequel après que le composant de réserve est automatiquement basculé lors du procédé de basculement de composant de réserve (S11), un ordre de montage est mis en oeuvre conformément à l'état d'alimentation en composants basculé pour le composant de réserve, en régénérant ainsi le programme de montage.

7. Dispositif de montage de composants qui prélève un composant (5) depuis une position d'agencement de composant indiquée par un programme de montage d'une partie d'alimentation en composants (16, 116) sur la base du programme de montage et monte le composant à une position de montage sur une carte à circuit imprimé (1),
ledit dispositif comprenant :
un moyen de détection d'absence de composant (202, 22) destiné à détecter l'absence du composant devant être monté à la position d'agencement de composant de la partie d'alimentation en composants indiquée par le programme de montage,
un moyen d'évaluation de détection de composant de réserve (202, 22), destiné à détecter si un composant de réserve pour le composant manquant devant être monté, est chargé ou non dans une zone d'alimentation en composants de réserve (16s) de la partie d'alimentation en composants, et à évaluer si le composant de réserve est situé ou non à l'intérieur de la zone d'alimentation en composants de réserve, et
un moyen de basculement de composant de réserve (202, 22) destiné à basculer la fourniture du composant devant être monté depuis la position d'agencement de composant indiquée de la partie d'alimentation en composants vers la fourniture du composant de réserve provenant de la zone d'alimentation en composants de réserve lorsque le composant de réserve est évalué comme étant présent à l'intérieur de la zone d'alimentation en composants de réserve par le moyen d'évaluation de détection de composant de réserve.

8. Dispositif de montage de composants selon la revendication 7, dans lequel la zone d'alimentation en composants de réserve (16s) de la partie d'alimentation en composants évaluée par le moyen d'évaluation de détection de composant de réserve (202, 22) est une zone autre qu'une zone d'alimentation en composants (16n) au niveau de laquelle la fourniture de composants est indiquée, dans le programme de montage conçu en vue de monter le composant sur la carte à circuit imprimé d'un type optionnel, de sorte que la fourniture du composant devant être monté provenant de la zone d'alimentation en composants de la partie d'alimentation en composants est basculée par le moyen de basculement de composant de réserve (202, 22) vers la fourniture du composant de réserve provenant de la zone d'alimentation en composants de réserve lorsque le composant de réserve est évalué comme étant présent dans la zone d'alimentation en composants de réserve par le moyen d'évaluation de détection de composant de réserve.

9. Dispositif de montage de composants selon la revendication 7, dans lequel la zone d'alimentation en composants de réserve (16s) de la partie d'alimentation en composants évaluée par le moyen d'évaluation de détection de composant de réserve (202, 22), est une zone en chevauchement avec une zone d'alimentation en composants (16n) au niveau de laquelle la fourniture de composants est indiquée dans le programme de montage conçu en vue de monter le composant sur la carte à circuit imprimé d'un type optionnel, de sorte que la fourniture du composant devant être monté provenant de la zone d'alimentation en composants de la partie d'alimentation en composants, .est basculée par le moyen de basculement de composant de réserve (202, 22) vers la fourniture du composant de réserve provenant de la zone d'alimentation en composants de réserve lorsque le composant de réserve est évalué comme étant présent dans la zone d'alimentation en composants de réserve, par le moyen d'évaluation de détection de composant de réserve.

10. Dispositif de montage de composants selon l'une quelconque des revendications 7 à 9, dans lequel le fait que le composant de réserve pour le composant manquant devant être monté soit chargé ou non dans la zone d'alimentation en composants de réserve (16s) de la partie d'alimentation en composants, est détecté par le moyen d'évaluation de détection de composant de réserve (202, 22), à l'intérieur de données de composants (20b) qui mémorisent au préalable des informations sur les types ou les caractéristiques et les positions d'agencement des composants agencés dans la zone d'alimentation en composants de réserve de la partie d'alimentation en composants, en évaluant ainsi si le composant de réserve est présent ou non dans la zone d'alimentation en composants de réserve.

11. Dispositif de montage de composants selon l'une quelconque des revendications 7 à 9, qui comprend un moyen de désignation de composant de réserve (21) destiné à désigner à enregistrer de façon préliminaire et, avant l'évaluation de détection de composant de réserve, une position d'agencement de composant du composant de réserve au niveau de la partie d'alimentation en composants qui peut remplacer le composant devant être monté si la partie d'alimentation en composants est dénuée du composant, tandis que le procédé d'évaluation de détection de composant de réserve détecte le composant de réserve correspondant au composant manquant devant être monté à partir des composants de réserve au niveau de la partie d'alimentation en composants désignée et enregistrée par le moyen de désignation de composant de réserve, en évaluant ainsi la présence/l'absence du composant de réserve correspondant au composant manquant devant être monté.

12. Dispositif de montage de composants selon l'une quelconque des revendications 7 à 11, qui comprend un moyen de réorganisation d'ordre de montage de composants (240) destiné à, après que le composant de réserve est automatiquement basculé par le moyen de basculement de composant de réserve (202, 22), mettre en oeuvre un ordre de montage conformément à un état d'alimentation en composants basculé par le composant de réserve, et en régénérant ainsi le programme de montage.
